# EUROPÄISCHE PATENTSCHRIFT

(11) **EP 1 753 048 B1**
(45) Veröffentlichungstag und Bekanntmachung des Hinweises auf die Patenterteilung: **20.08.2008**
(21) Anmeldenummer: 05017542.1
(22) Anmeldetag: 11.08.2005
(51) Int. Cl.: H01L 51/52

(54) **Verfahren zum Herstellen eines top-emittierenden Bauteils sowie Verwendung**
Method of making a top-emitting element and its use
Procédé de fabrication d'un dispositif emettant par le haut et son utilisation

(43) Veröffentlichungstag der Anmeldung: 14.02.2007
(73) Patentinhaber: Novaled AG, 01307 Dresden (DE)
(72) Erfinder: Murano, Sven, 01127 Dresden (DE); Birnstock, Jan, 01187 Dresden (DE)
(74) Vertreter: Bittner, Thomas L.

(56) Entgegenhaltungen:
- EP-A- 1 406 474
- US-A1- 2001 038 102
- US-A1- 2003 062 636
- US-A1- 2003 164 679
- US-A1- 2004 012 980
- US-A1- 2004 227 446
- US-B1- 6 476 550

## Beschreibung

Die Erfindung betrifft Verfahren zum Herstellen eines top-emittierenden Bauteils, insbesondere organische Leuchtdiode, mit einer auf einem Substrat aufgebrachten Schichtanordnung, welche eine auf dem Substrat angeordnete Grundelektrode und eine Deckelektrode, durch welche hindurch eine Lichtemission erfolgt, sowie einen zwischen der Grundelektrode und der Deckelektrode angeordneten Stapel organischer Schichten umfaßt, sowie dessen Verwendung.

### Stand der Technik

Organische lichtemittierende Dioden, die abgekürzt üblicherweise auch als OLEDs bezeichnet werden, besitzen insbesondere in einer Ausführung zur Weißlichterzeugung ein hohes Potential für Anwendungen im Bereich der Beleuchtung und der Displays. In den letzten Jahren konnten auf diesem Gebiet deutliche Verbesserungen erzielt werden, sowohl bei den erzielten Effizienzen als auch hinsichtlich der Lebensdauern der Bauteile. Die Leistungseffizienzen von weißen OLEDs liegen heute im Bereich von 10 bis 25 1m/W, und Lebensdauern von mehr als 10000 Stunden sind realisierbar. Für eine breit angelegte Kommerzialisierung im Bereich allgemeiner Beleuchtungsanwendungen sind jedoch noch Verbesserungen insbesondere hinsichtlich der Leistungseffizienz notwendig, da momentan der Markt von hocheffizienten Technologien zur Erzeugung von Weißlicht, wie beispielsweise Leuchtstoffröhren, mit Effizienzen von bis zu 100 1m/W beherrscht wird.

Es ist allgemein bekannt, dass gewöhnliche OLEDs nur etwa 25% des generierten Lichtes emittieren, während der Großteil aufgrund ungünstiger optischer Gegebenheiten in optischen Moden des Substrates oder der organischen Schichten verbleibt und somit verloren geht. Der Grund hierfür liegt darin, dass das Licht innerhalb einer OLED in optischen Medien mit einem Brechungsindex von etwa 1,3 bis 1,8 gebildet wird. Trifft dieses Licht nun auf ein optisches Medium mit einem niedrigeren Brechungsindex, beispielsweise eine weitere Schicht innerhalb eines OLED-Stapels, das Substrat, auf welchem die OLED gebildet ist, oder eine der Elektroden, so kommt es zu einer Totalreflexion, sofern ein gewisser Wert des Einfallswinkels überschritten wird.

Insbesondere beim Übergang des Lichtes in Luft tritt ein solcher Brechungsindexsprung notwendigerweise auf, wodurch lediglich Licht, welches unter relativ kleinen Winkeln auf die Grenzfläche zur Luft trifft, das OLED-Bauteil verlassen kann. Dieser Grenzwinkel für die Totalreflexion beträgt beim Übergang zu Luft arcsin(1/n), wobei n der Brechungsindex des an Luft grenzenden Materials ist.

Es sind vielfältige Überlegungen bekannt, welche auf eine Verbesserung dieser Lichtauskopplung abzielen. Zu nennen wären in diesem Zusammenhang beispielsweise das Aufbringen von Streufolien, Mikrolinsen oder speziell strukturierter Oberflächen auf eine Substratseite der OLED, welche die Grenzfläche zur Luft hin bildet und wo ein Großteil der unerwünschten Totalreflexion des Lichtes erfolgt. Diese Maßnahmen haben zum Ziel, Licht, welches in den transparenten Substraten der OLEDs "gefangen ist", auszukoppeln.

Bauelemente auf Basis von OLEDs hingegen, welche auf einem reflektierenden Grundkontakt aufgebracht werden, so genannte top-emittierende OLEDs, werden in ihrer Leistungsfähigkeit nicht durch Verluste im transparenten Substrat limitiert. Trotzdem ist auch hier die Lichtausbeute grundsätzlich durch Verlustmechanismen eingeschränkt, da ein Großteil des emittierten Lichtes nun innerhalb der organischen Schichten der OLED aufgrund von Totalreflexion "gefangen ist". Mögliche Verbesserungen der Lichtausbeute sind auch hier bekannt, insbesondere mittels Ausbildung so genannter Mikrokavitäten oder auch mit Hilfe zusätzlicher Auskoppelschichten, welche die Reflexionsbedingungen an der Grenzfläche der OLED zu Luft hin verbessern.

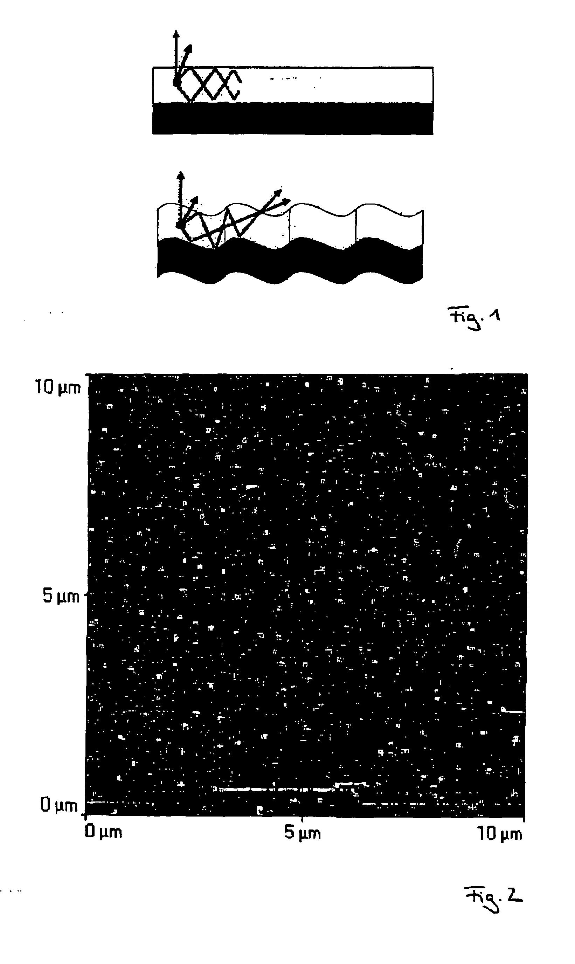

Trotz der bereits erzielten Verbesserungen zur Auskopplung des emittierten Lichtes sind im Vergleich zum Stand der Technik noch erhebliche Verbesserungen notwendig, insbesondere betrifft dies Licht, welches in den Moden der organischen Schichten der OLED selber eingeschlossen ist. Es ist bekannt, dass das hier eingeschlossene Licht grundsätzlich nutzbar wird, sobald die organischen Schichten sich nicht auf einem glatten Substrat befinden, sondern dieses beispielsweise gerillt ist. Hierdurch trifft Licht unter unterschiedlichen Winkeln auf die Grenzfläche des Bereiches organischer Schichten und kann so ausgekoppelt werden, was in Fig. 1 schematisch dargestellt ist. Diese Beschreibung mittels geometrischer Strahlenoptik ist in Anbetracht von Schichtdicken, die auch unterhalb der Lichtwellenlänge liegen können, zwar nur näherungsweise korrekt, beschreibt aber in ausreichendem Maße die Phänomenologie nicht glatter Substrate. Solche Verfahren sind bereits beschrieben worden, beispielsweise im Dokument GB 2361356 A für transparente Substrate mit transparenter Grundkontaktelektrode oder im Dokument GB 2390215 A für Aktivmatrixanzeigeelemente mit gerillter Pixel-Struktur.

Für die Verwendung von weißen OLEDs in der Beleuchtungstechnologie ist es also notwendig, geeignete Auskopplungsmethoden zur Anwendung zu bringen, welche sich darüber hinaus preisgünstig in den Fertigungspzozess einbinden lassen. Es wird heute davon ausgegangen, dass eine Fläche einer OLED von 1 cm² für Beleuchtungsanwendungen nur wenige Cent kosten darf, damit deren Anwendung wirtschaftlich sinnvoll ist. Das bedeutet aber auch, dass für die Erhöhung der Lichtauskopplung nur besonders preisgünstige Verfahren überhaupt in Frage kommen.

Für Anwendungen von OLEDs als Beleuchtungselemente ist es weiterhin notwendig, die Bauteile großflächig auszuführen. Wird beispielsweise eine OLED bei einer Helligkeit von 1000 cd/m² betrieben, so werden Flächen im Bereich einiger Quadratmeter benötigt, um beispielsweise einen Büroraum auszuleuchten.

Bei dem Bau von OLEDs dieser Größe ergibt sich aber ein Problem mit der Elektrodenleitfähigkeit der transparenten Elektrode des Bauteils. Üblicherweise werden OLEDs auf transparenten, mit ITO (Indium-Zinn-Oxid) beschichteten Substraten aufgebracht, wobei ITO jedoch je nach Schichtdicke und Zusammensetzung einen Schichtwiderstand von 5 bis 100 Ω/∀ aufweist. Für großflächige OLEDs werden jedoch deutlich geringere Schichtwiderstände benötigt, da relativ hohe Ströme durch die Elektroden transportiert werden müssen und somit ein deutlicher Spannungsabfall über den Elektroden auftreten kann, sofern diese nicht sehr geringe Widerstände kleiner als beispielsweise 1 Ω/∀ aufweisen. Dieser Effekt führt aufgrund des Schichtwiderstandes des ITOs bereits bei OLED-Flächen von einigen Quadratzentimetern zu deutlichen Helligkeitsabfällen. Um dieses Problem zu vermindern, kann das ITO mit zusätzlichen Metallbahnen verstärkt werden, welche dann den Großteil der fließenden Ströme transportieren. Hierzu müssen die Metallbahnen jedoch einen gewissen Durchmesser aufweisen, weswegen sie üblicherweise eine Höhe von einigen hundert Nanometern haben, da sie anderenfalls zu breit wären, wodurch die aktive Fläche des OLED-Bauelements zu stark reduziert wird. Bei der Verwendung von transparenten, ITO-beschichteten Substraten mit einer Metallverstärkung ist dann allerdings eine Passivierung der Metallbahnen mit einer Isolatorschicht notwendig, da anderenfalls Kurzschlüsse zwischen der Grund- und der Deckelektrode des Bauteils auftreten können.

Unter Berücksichtigung dieser Tatsachen erscheint die Verwendung von hochleitfähigen Grundkontakten auf dem Substrat sinnvoll. Elektroden mit einer entsprechend hohen Leitfähigkeit von < 1 Ω/∀ können beim Stand der Technik nur mit Metallen erzielt werden. Entsprechende Leitfähigkeiten können allerdings nur mit Schichtdicken erreicht werden, welche dann, nur eine sehr geringe Transparenz aufweisen oder nicht transparent sind. Somit muss bei der Verwendung von hochleitfähigen Grundkontakten die OLED über eine transparente Deckelektrode verfügen, so daß sie top-emittierend ausgeführt sein muss. Eine solche transparente Deckelektrode kann beispielsweise aus dünnen Metallschichten oder ITO bestehen.

Zwar gelten die Überlegungen hinsichtlich des Schichtwiderstandes auch für die Deckelektrode in gleichem Maße, also reicht auch hier die Leitfähigkeit der transparenten Elektrode nicht aus, um den in der OLED fließenden Strom ohne signifikante Spannungsverluste zu transportieren, sofern das Bauteil eine gewisse Größe überschreitet, wie sie für Beleuchtungsanwendungen notwendig erscheint. Allerdings lässt sich eine Verstärkung der Deckelektrode mittels metallischer Leiterbahnen hierbei deutlich leichter erzielen, da nun auf einen zusätzlichen Passivierungsschritt verzichtet werden kann. Die metallischen Verstärkungen zum Stromtransport können nämlich auf die Deckelektrode beispielsweise in Form eines Gitters aufgebracht werden, die Gefahr einer Kurzschlussbildung zwischen Anode und Kathode der OLED muss nicht mehr berücksichtigt werden.

Hierbei ist die Prozessierung der Metallbahnen relativ einfach, da lediglich Strukturen in Dimensionen gebildet werden müssen, die einen Stromfluss durch die Deckelektrode ohne einen signifikanten Spannungsabfall ermöglichen. Beispielsweise könnten die Metallbahnen ein Raster mit einer Maschenweite von etwa einem Zentimeter bilden, wodurch sich der Spannungsabfall über die so entstandenen segmentierten transparenten Elektrodenteilflächen bereits auf einen unbedeutenden Wert minimieren lässt.

Zwar gibt es auch alternative Ansätze zur Umgehung des Problems, welches sich aufgrund eines seriellen Widerstandes beim Stromtransport ergibt. Insbesondere ist hier zu nennen, dass verschiedentlich die Reihenschaltung von OLED-Einheiten innerhalb eines Bauteils vorgeschlagen wurde. Eine solche Lösung setzt jedoch eine komplexere Strukturierung des Substrates sowie zusätzliche Maskierungsschritte voraus.

Da für top-emittierende OLEDs in letzter Zeit wesentliche Fortschritte sowohl im Hinblick auf die Effizienz als auch im Hinblick auf die Lebensdauern erzielt wurden, kann davon ausgegangen werden, dass im Bereich der Beleuchtungsanwendungen top-emittierende Strukturen von sehr großem Interesse sind, unter anderem auch wegen der Möglichkeit, auf JTO als Material zu verzichten, welches einen bedeutenden Kostenpunkt für OLEDs darstellt. Für einen wirtschaftlichen Durchbruch der OLED-Technologie ist jedoch - wie bereits erwähnt - insbesondere eine kostengünstige Produktion bei gleichzeitig hoher Effizienz des Bauteils notwendig. Hierfür werden beispielsweise Produktionsverfahren in einem "roll-to-roll"-Prozess ins Auge gefaßt. Um eine wirtschaftlich konkurrenzfähige OLED-Beleuchtungstechnologic zu entwickeln, ist es weiterhin insbesondere notwendig, eventuelle Auskopplungsverfahren kostengünstig zu gestalten.

Bisher konnte die OLED-Technologic für Anwendungen als Beleuchtungselemente nicht kommerzialisiert werden, insbesondere da Effizienzen und Preis von OLEDs noch nicht konkurrenzfähig sind. Zwar sind Verfahren beschrieben, in welchen Streugitter (siehe US 6,476,550), zweidimensionale photonische Strukturen (siehe US 6,630,684), Hologramme oder dergleichen zum Zwecke der Auskopplungsverbesserung in OLEDs integriert werden, diese Verfahren beruhen jedoch auf verhältnismäßig komplexen Prozessschrittcn, beispielsweise Photolithographie.

Für sogenannte bottom-emittierende OLED-Strukturen, in welchen ein transparentes Substrat verwendet wird, durch das hindurch die Lichtemission nach unten erfolgt, wurde vorgeschlagen, regelmäßige Strukturen mittels eines Stempels aufzubringen (siehe GB 2361356 A). In diesem Dokument werden Verfahren beschrieben zur Herstellung einer gerillten Oberfläche auf einem transparenten Substrat, wobei Polymerschichten unter Verwendung eines Werkzeuges gebildet werden. Hierbei werden Verfahren offenbart, in denen die Formgebung mittels Fotoaushärtung eines flüssigen Polymeres erfolgt, welches während der Aushärtung mit Hilfe eines Formwerkzeuges in Form gehalten wird, oder bei welchen eine Polymerlösung mittels eines Werkzeuges geformt wird und hierbei aufgrund des Verdampfens des Lösungsmittels aushärtet. Für top-emittierende OLED-Strukturen hingegen werden nach dem Stand der Technik mittels komplexer Verfahren (siehe GB 2390215 A), beispielsweise Photolithographie, strukturierte Grundelektroden eingesetzt, welche für eine kostengünstige Massenproduktion nicht in Frage kommen. Ein Grund hierfür ist darin zu sehen, dass im Stand der Technik für top-emittierende OLEDs davon ausgegangen wird, dass die Oberflächen der verwendeten Substrate sehr glatt sein müssen, da sich auf rauhen Oberflächen Kurzschlüsse bilden. Im Fall der bottom-emittierende Bauteile ist eine ganz andere Grundelektrode, die meist aus einem leitenden Glas ist, vorgesehen, während typische Grundelektroden für top-emittierende Bauteile üblicherweise aus einem Metall oder einem Metallstapel sind. Dieser Unterschied an der Grenzfläche zwischen Substrat und dem Bereich organischer Schichten bedeutet, dass hinsichtlich der Architektur des Bereichs organischer Schichten und des Substrates für top-emittierende und bottom-emittierende Bauteile sehr unterschiedliche Anforderungen bestehen. So sind nur wenige hoch-effiziente und langlebige top-emittierende Bauteile bekannt, wohingegen eine Vielzahl von bottom-emittierenden Bauteilen beschrieben wurden.

Insbesondere stellt die Rauhigkeit der Grundelektrode ein Problem für eine Prozessierung von OLEDs dar, da üblicherweise sehr dünne Gesamtschichtdicken von etwa 100 nm für den Bereich der organischen Schichten in dem OLED-Stapel verwendet werden, wodurch eine Gefahr der Kurzschlussbildung zwischen den Elektroden besteht. Aus diesem Grunde müssen beispielsweise in Aktivmatrix-Anzeigeelementen entweder spezielle Planarisierungsschichten eingesetzt werden, oder aber die Grundelektrodenoberfläche muss so ausgestaltet sein, dass vorhandene Höhenunterschiede mit geeignet flachen Kantenwinkeln versehen werden, wodurch sich eine Kurzschlussneigung unterdrücken lässt.

In dem Dokument US 6,476,550 B1 ist ein top-emittierendes Bauteil offenbart, bei dem auf einem Substrat mit einer rauhen Oberfläche ein organisches Bauelement mit einer der rauen Oberfläche des Substrates gebildeten Grundelektrode und einer Deckelektrode sowie einer hierzwischen gebildeten organischen Schicht offenbart. Das Substrat wird in dem beschriebenen Ausführungsbeispielen von einem Träger, nämlich Glas, und einer hierauf angeordneten Schicht gebildet, die zum Ausbilden der rauhen Oberfläche photolitographisch bearbeitet wird.

Das Dokument US 2001/0038102 A1 beschreibt ein organisches lichtemittierendes Bauteil bei dem ein zweikomponentiges Substrat mit einer rauhen Oberflächenstruktur versehen ist, die gebildet wird, indem auf ein Trägersubstrat eine Harzschicht aufgebracht wird, die dann mittels eines Prägestempels bearbeitet wird.

Im Dokument US 2004/0012980 ist das Ausbilden einer rauhen Oberfläche einer Grundelektrode mittels Bürsten beschrieben.

Das Dokument US 2004 / 0227446 A1 beschäftigt sich mit einer Displayeinrichtung, bei der auf ein Substrat eine mehrschichtige Anordnung aufgebracht wird.

Im Dokument EP 1 406 474 A1 wird die Nutzung einer Licht streuenden Schicht zwischen einem Substrat und einer OLED beschrieben.

Auch nach dem Dokument US 2003 / 0164679 A1 werden zusätzliche Schichten auf ein Substrat aufgebracht und dann bearbeitet.

Das Dokument US 2003 / 0062635 A1 betrifft die Ausbildung eines Materials mit einem Brechungsindexgradienten mittels Anmischen eines Ausgangsmaterials und anschließendem Walzverfahren.

Aus dem Dokument US 2003 / 0164679 A1 ist ein organisches elektrolumineszentes Element bekannt, welches für Anzeigenpixel nutzbar ist und bei dem zur verbesserten Lichtauskopplung V-förmige Strukturelemente auf ein Substrat aufgeprägt sind. In verschiedenen Ausführungsbeispielen weisen die Strukturelemente Höhen von 30 µm bzw. 50 µm auf.

### Die Erfindung

Aufgabe der Erfindung ist es, ein Verfahren zum Herstellen eines top-emittierenden Bauteils mit einer verbesserten Lichtauskopplung zu schaffen, welches kostengünstig produziert werden kann und für einen Massenfertigungsprozess geeignet ist.

Diese Aufgabe wird erfindungsgemäß durch ein Verfahren zum Herstellen eines top-emittierenden Bauteils nach dem unabhängigen Anspruch 1 gelöst. Vorteilhafte Ausgestaltungen der Erfindung sind Gegenstand von abhängigen Unteransprüchen.

Überraschend wurde in Experimenten festgestellt, dass auch auf rauhen Oberflächen, die aufgrund der Oberflächenstruktur gebildet sind, langlebige top-emittierende Bauteile mit sehr niedrigen Sperrströmen hergestellt werden können. Die niedrigen Sperrströme gelten als Nachweis, dass es trotz des rauhen Substrates nicht zu Kurzschlüssen zwischen Grund- und Deckelektrode kommt. Die mechanische Formgebung zum Ausbilden der Oberflächenstruktur ermöglicht eine kostengünstige Massenfertigung, insbesondere weil das Formgebungswerkzeug für die Herstellung einer Vielzahl von Bauteilen verwendet werden kann.

Erstmals wird ein top-emittierendes Bauteil mit einem Stapel organischer Schichten vorgeschlagen, das auf einer sehr rauhen Oberfläche sowohl hohe Effizienz als auch hohe Lebensdauer und sogar niedrige Ströme in Sperrrichtung aufweist. Dieses Ergebnis ist überraschend und das Resultat umfangreicher Versuchsreihen und langer Optimierung. Top-emittierende Bauteile haben ein hohes Potential als markttaugliche Technologie und können auf einfache Art hergestellt werden. Somit ist die Erfindung ein wichtiger Baustein für eine zukünftige Massenproduktion von organischen lichtemittierenden Bauteilen für Beleuchtungsanwendungen.

Die mechanische Formgebung kann beispielsweise mittels Stempeln ausgeführt werden. Zur Herstellung eines Stempels mit einer entsprechenden Oberflächenstruktur kann es beispielsweise vorgesehen sein, eine Siliziumoberfläche mittels photolithographischer Verfahren zu strukturieren. Die Strukturierung von Silizium auf diesem Wege ist technisch bekannt, es können hierbei Strukturen im Submikrometerbereich hergestellt werden. Aufgrund der permanenten Fortentwicklung auf dem Gebiet der Halbleitertechnologie sind weitere lithographische Herstellungsverfahren, beispielsweise EUV-Lithographie oder Röntgenlithographie grundsätzlich für die Herstellung solcher Oberflächen denkbar. Zwar ist die Herstellung eines entsprechenden Stempels grundsätzlich mit einem hohen Aufwand und hohen Kosten verbunden, jedoch kann ein solcher Stempel für eine sehr große Zahl von herzustellenden Bauteilen verwendet werden, wodurch deren kostengünstige Herstellung gewährleistet ist.

Ein Verfahren zum Strukturieren von Polymeroberflächen wird in der Dissertation von Natalie Stutzmann beschrieben (Dissertation ETH Zürich 2001, Technische Wissenschaften ETH Zürich, Nr. 14046, 2001). Dieses Dokument befasst sich mit den Möglichkeiten, polymere Materialien mittels Standardverfahren, insbesondere Prägen zu bearbeiten, um mikrostrukturierte Oberflächen in einer einfachen und unkomplizierten Fabrikationsweise herzustellen.

Bei einer Ausführungsform der Erfindung ist vorgesehen, dass die mittels mechanischer Formgebung gebildete Oberflächenstruktur nicht regelmäßig ausgeführt ist. Bevorzugt ist die Strukturierung der Oberfläche mit Strukturen in Dimensionen von etwa 50 nm bis etwa 50 µm ausgeführt, insbesondere in Dimensionen der Wellenlängen von sichtbarem Licht. Grundsätzlich erfolgt die Streuung von elektromagnetischen Wellen nach zwei unterschiedlichen Mechanismen, der so genannten Rayleigh-Streuung und der so genannten Mie- oder Lorenz-Mie-Streuung. Während erstere an Objekten mit deutlich kleineren Dimensionen als die Wellenlänge der gestreuten Strahlung erfolgt und relativ schwach ist, erfolgt letztere an Strukturen mit Dimensionen im Bereich der Strahlungswellenlänge und ist relativ stark. Rayleigh-Streuung erfolgt stark wellenlängenabhängig, während Mie-Streuung weitestgehend wellenlängenunabhängig erfolgt. Der Vorteil bei der Benutzung von Streuzentren / -Strukturen in der Größenordnung der Lichtwellenlänge ist also ein zweifacher: Die Streuung erfolgt in größerem Umfang, wodurch eine höhere Auskopplungssteigerung erreicht werden kann, und sie erfolgt unabhängig von der Farbe des Lichtes, was natürlich erwünscht ist, denn eine wellenlängenabhängige Auskopplungssteigerung hätte eine Farbverfälschung des Beleuchtungselementes zur Folge.

Der Zweck der Unregelmäßigkeit der eingeprägten Oberflächenstruktur besteht darin, dass regelmäßige Strukturen zu einer Winkelabhängigkeit des Streuverhaltens im Bereich der aufgebrachten Oberflächenstruktur fuhren. Dies ist aber insbesondere im Falle einer breitbandigen Lichtemission, wie sie im Falle von weißem Licht gegeben ist, nicht wünschenswert, da dann das Beleuchtungselement unter unterschiedlichen Betrachtungswinkeln verschiedenfarbiges Licht emittieren würde. Es wird deshalb eine Auskoppelstruktur gewählt, die idealerweise die Winkelabhängigkeit der Emission unterdrückt, anstatt diese zu fördern.

Als Materialien für die Schicht mit der Oberflächenstruktur, welche mittels mechanischer Formgebung, insbesondere einem Prägeprozess gebildet ist, kommen vorzugsweise duktile oder thermoplastische Polymere in Frage, beispielsweise Fluoroethylenpropylen (FEP). Die Wahl der Polymere wird von unterschiedlichen Kriterien beeinflusst, beispielsweise werden bevorzugt Materialien ausgewählt, welche nur über eine sehr geringe Haftungsneigung an anderen Materialien verfügen. Hierfür kommen dann insbesondere perfluorierte Polymere oder Polyolefine in Frage, Substanzen, welche für ihre nicht-adhäsiven Eigenschaften bekannt sind. Wegen der geringen Haftungsneigung wird der Ablösevorgang des mechanischen Werkzeugs zum Ausbilden der Oberflächenstruktur, bei dem es sich beispielsweise um einen Stempel handelt, erleichtert. Weiterhin wird insbesondere die Bildung von mechanischen Defekten im geprägten Polymer beim Ablösen verringert.

Darüber hinaus ermöglicht die Erfindung die Verwendung von Polymeren mit schlechten optischen Eigenschaften, insbesondere von teilkristallinen Polymeren. Zwar zeigen diese eine deutlich geringere Transparenz als amorphe Materialien, wie sie beispielsweise in CDs oder DVDs verwendet werden, dafür haben sie aber deutlich verbesserte mechanische Eigenschaften. Insbesondere zeichnen sich teilkristalline Polymere dadurch aus, dass sie oberhalb der Glasübergangstemperatur und unterhalb der Schmelztemperatur mechanisch fest sind, hierbei jedoch im Gegensatz zu amorphen Polymeren nicht brüchig sind. Somit verringert sich die Gefahr einer Defektbildung beim Ablösen des mechanischen Formgebungswerkzeugs, wodurch, die Ausbeute im Gesamtprozess der Bauteilherstellung erhöht wird.

Die Verwendung solcher teilkristalliner Materialien als aufgerauhte Substratoberfläche ist jedoch nur im Falle einer top-emittierenden OLED möglich, da anderenfalls die schlechten optischen Eigenschaften die Effizienz des OLED-Bauteils zu stark beeinträchtigen würden.

Alternativ kann bei einer Ausgestaltung der Erfindung vorgesehen sein, zum Ausbilden der Oberflächenstruktur eine Metallschicht mittels mechanischer Formgebung zu bearbeiten. Metalle lassen sich mittels verschiedener mechanischer Formgebungsverfahren bearbeiten, die dem Fachmann als solche bekannt sind. Hierzu gehören zum Beispiel das Prägen, das Bürsten und das Drucken. Bei dieser Ausführungsform ist die Metallschicht auf der dem Stapel organischer Schichten zugewandten Seite mit einer Isolierschicht versehen sein, die beispielsweise aus einem Polymer oder Siliziumoxid ist.

Das Ausbilden der Oberflächenstruktur mittels mechanischer Formgebung kann bei den verschiedenen Ausgestaltungen der Erfindung vor dem Ausbilden der Grundelektrode oder nach deren Aufbringen ausgeführt werden.

In einer Ausführungsform ist die Verwendung dotierter Ladungsträgertransportschichten vorgesehen, was den Vorteil hat, dass die Ladungsträgertransportschichten sehr dick, nämlich zwischen einigen 10 und einigen 100 nm, ausgebildet werden können. Das Bauteil ist dadurch weniger anfällig gegenüber rauhen Substraten. Darüber hinaus ermöglicht die Verwendung von dotierten Schichten den Einsatz einer Vielzahl möglicher Elektrodenmaterialien, da die Austrittsarbeit des Elektrodenmaterials bei der Injektion von Ladungsträgern in dotierte Schichten nur einen geringen Einfluss ausübt

### Bevorzugte Ausführungsbeispiele der Erfindung

Die Erfindung wird im folgenden anhand von Ausführungsbeispiele unter Bezugnahme auf Figuren einer Zeichnung näher erläutert. Hierbei zeigen:
- Fig. 1: schematische Darstellung zur Erläuterung einer Lichtreflexion an einer ebenen und einer mit einer Oberflächenstruktur versehenen Oberfläche;
- Fig. 2: experimentelle Ergebnisse für eine Messung einer Oberflächenstruktur mittels Rasterkraftmikroskopie;
- Fig. 3: eine Stromdichte-Spannungs-Charakteristik für ein top-emittierendes Bauelement;
- Fig. 4: eine Helligkeit-Spannungs-Charakteristik für das top-emittierendes Bauelement;
- Fig. 5: eine grafische Darstellung der Helligkeit in Abhängigkeit von der Betriebszeit für das top-emittierendes Bauelement;
- Fig. 6: eine schematische Darstellung für eine Oberflächengestaltung eines Prägestempels oder einer Prägewalze; und
- Fig. 7: eine schematische Darstellung für eine weitere Oberflächengestaltung eines Prägestempels oder einer Prägewalze.

Auf einem Glassubstrat wird bei einer Temperatur von 330 °C auf einer Heizplatte ein Polytetrafluoroethylen-co-hexafluoropropylen (FEP)-Pellet aufgeschmolzen und mittels eines Silziumwafers zu einem Film auf der Glasoberfläche verpresst. Anschließend wird das Glassubstrat von der Heizplatte entfernt und auf einer kalten Oberfläche abgekühlt. Nun wird der Siliziumwafer von dem erkalteten FEP-Film entfernt.

Der verwendete Siliziumwafer wurde zuvor mittels kurzzeitigem Eintauchens in Flusssäure aufgeraut. Hierdurch entsteht eine Oberflächenstruktur in der Siliziumdioxidschicht des Wafers mit einer Peak-Valley-Rauhigkeit von etwa 100 nm, welche sich als negativer Abdruck auf den FEP-Film überträgt.

Anstelle des Siliziumwafers kann auch eine polierte Stahlplatte zum Einsatz kommen, in welche zum Beispiel mit einem Laser oder auf photolithigraphischem Wege unregelmäßige Strukturen, die eine mittlere Ausdehnung von etwa 300 nm haben, eingebracht wurden. Durch das Pressen der Stahlplatte auf das Polymer werden diese Strukturen als negativer Abdruck auf das Polymer übertragen.

Anstelle einer flächigen Stahlplatte, kann auch eine Walze aus poliertem Stahl zum Stempeln verwendet werden. Diese weist unregelmäßige erhabene oder tiefliegende Strukturen in der Größenordnung von 1 µm auf In diesem Fall wird das Polymer nicht bis auf 330 °C erhitzt, sondern bei einer Temperatur zwischen 20 °C und 150 °C strukturiert. Anstelle eines Substrates, das aus Glas und einer Polymerschicht besteht, kann auch ein so genannter freistehender, flexibler Polymerfilm in einem Rolle-zu-Rolle-Verfahren, wie es aus der Druckindustrie wohl bekannt ist, strukturiert werden.

Um einen metallischen Grundkontakt mit der entsprechenden Rauhigkeit zu erzielen, wird nun in einem zweiten Schritt mittels thermischer Verdampfung eine 50 nm dicke Schicht Aluminium oder Silber oder Chrom auf das Substrat aufgedampft.

Die Rauhigkeit eines solchen Chromgrundkontaktes wurde mittels Rasterkraftmikroskopie vermessen und wies eine Peak-Valley-Rauhigkeit von 70nm auf (Fig. 2). Diese Schicht wurde nun als Anode (Grundelektrode) für eine top-emittierendes Bauteil mit folgendem Schichtaufbau verwendet:
(1) 70nm. MeoTPD dotiert mit 4 % F4-TCNQ
(2) 10nm α-NPD
(3) 20nm TCTA dotiert mit 10 % fac-tris(2-phenylpyridine) iridium (Ir(ppy)3)
(4) 10nm Bathophenanthrolin
(5) 50nm Bathophenanthrolin dotiert mit Cs (1:1 molare Mischung)
(6) 15nm Silber als Kathode

Die Schichten (1) bis (5) bilden einen Stapel organischer Schichten, auf welchem dann in Form der Schicht (6) die Kathode als Deckelektrode aufgebracht ist.

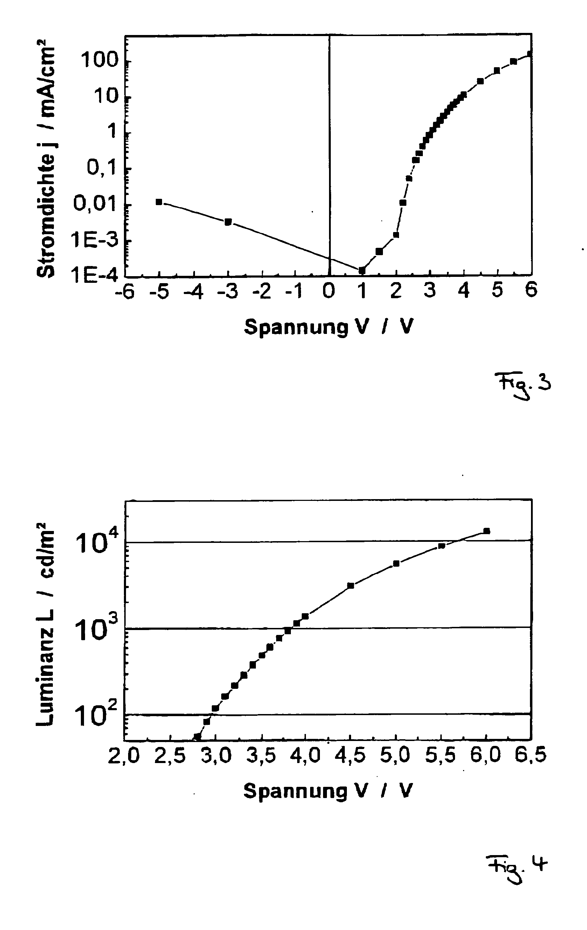

Dieses organische lichtemittierende Bauteil zeigt bei einer Spannung von 3 V eine Stromeffizicnz von 14.6 cd/A bei einer Helligkeit von über 100 cd/m² und verfügt über eine gute Strom-Sparmungscharakteristik und ein hohes Sperrverhältnis von ~ 104 bei * 5 V (Fig. 3). Eine Helligkeit von 1000cd/m² wird unterhalb von 4 V erreicht (Fig. 4).

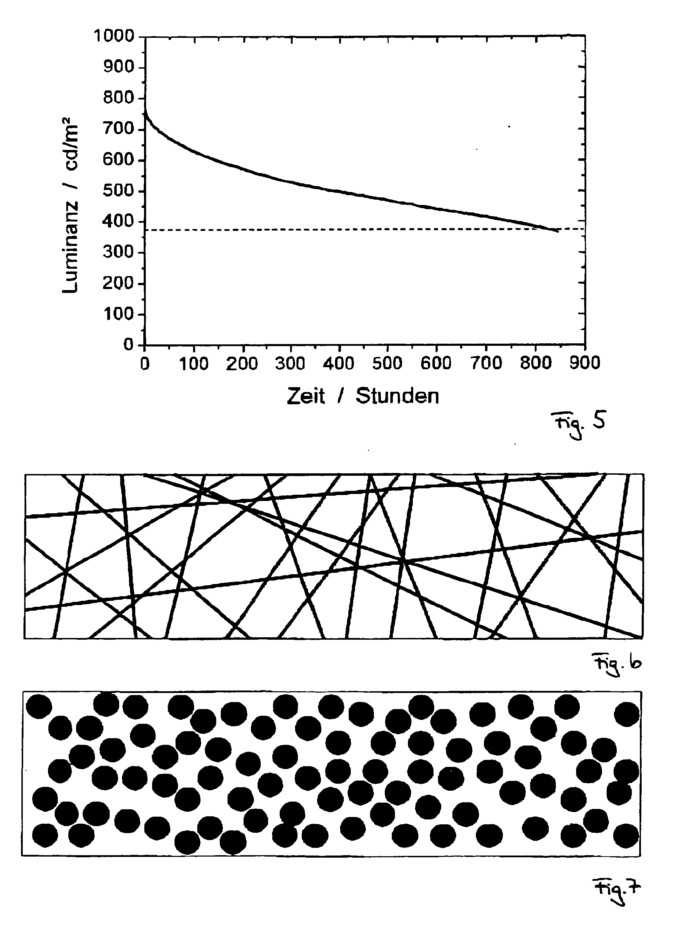

Die Lebensdauer dieses OLED-Bauteils beträgt mehr als 800 Stunden bei einer Starthelligkeit von etwa 850 cd/m² (siehe Fig. 5). Eine vergleichbare Referenzdiode auf einem, glatten Substrat bringt hingegen nur eine Stromeffizienz von 12.0 cd/A bei einer Helligkeit von 100 cd/m².

Die Fig. 6 und 7 zeigen schematische Darstellungen für mögliche Oberflächengestaltungen eines Prägestempels oder einer Prägewalze zur Verwendung bei der mechanischen Formgebung. Hierbei zeigt Fig. 6 eine Oberfläche, welche mit einem unregelmäßigen Rillenmuster überzogen ist, wohingegen Fig. 7 eine Oberfläche mit punktförmigen Strukturen in einer zufälligen Anordnung zeigt. Die Prägestrukturen können sowohl in Form von Vertiefungen aus einer Vorlage aufgebracht sein, als auch in Form von erhabenen Strukturen. Darüber hinaus ist eine Vielzahl an möglichen Gestaltungen für die Form der Strukturen denkbar. Die Rillen können ein rundes oder ein eckiges Profil haben, die punktförmigen Strukturen könnten beispielsweise in Form von Kegelstümpfen ausgeführt sein.

Die gezeigten Muster sind jedoch nur beispielhaft, grundsätzlich kann jegliche Art der Oberflächenprägung verwendet werden. Bevorzugt werden Prägestrukturen gewählt, deren Profil wenig scharfkantig ist, um die Gefahr von Kurzschlüssen im Stapel organischer Schichten zu vermeiden.

Die in der vorstehenden Beschreibung, den Ansprüchen und den Zeichnungen offenbarten Merkmale der Erfindung können sowohl einzeln als auch in beliebiger Kombination für die Verwirklichung der Erfindung in ihren verschiedenen Ausführungsformen von Bedeutung sein.

## Patentansprüche

1. Verfahren zum Herstellen eines top-emittierenden Bauteils, insbesondere organische Leuchtdiode, bei dem:
- eine Schichtanordnung auf einem Substrat aufgebracht wird,
- die Schichtanordnung mit einer auf dem Substrat angeordneten Grundelektrode und eine Deckelektrode, durch welche hindurch eine Lichtemission erfolgt, sowie einem zwischen der Grundelektrode und der Deckelektrode angeordneten Stapel organischer Schichten gebildet wird, und
- eine dem Stapel organischer Schichten zugewandte Oberfläche der Grundelektrode zumindest in einem Teilbereich lichtreflektierend gebildet und mit einer eine Reflexion von in dem Stapel organischer Schichten erzeugtem Licht an der Grundelektrode definierenden Oberflächenrauhigkeit versehen wird,
**dadurch gekennzeichnet, dass**
- das Substrat als eine Polymerschicht oder eine Metallschicht gebildet wird und
- im Bereich der dem Stapel organischer Schichten zugewandten Oberfläche mittels mechanischer Formgebung, nämlich Prägen mittels Stempeln oder Druckwalzen, eine geprägte Oberflächenstruktur mit Strukturelementen mit Abmessungen im Bereich der Wellenlänge von sichtbarem Licht gebildet wird.

2. Verfahren nach Anspruch 1, **dadurch gekennzeichnet, dass** die Polymerschicht aus einem duktilen Polymermaterial gebildet wird.

3. Verfahren nach Anspruch 1, **dadurch gekennzeichnet, dass** die Polymerschicht aus einem thermoplastischen Polymermaterial gebildet wird.

4. Verfahren nach Anspruch 1, **dadurch gekennzeichnet, dass** die Polymerschicht aus einem teilkristallinen Polymermaterial gebildet wird.

5. Verfahren nach einem der vorangehenden Ansprüche, **dadurch gekennzeichnet, dass** die geprägte Oberflächenstruktur als eine unregelmäßige Oberflächenstruktur gebildet wird.

6. Verfahren nach einem der vorangehenden Ansprüche, **dadurch gekennzeichnet, dass** der Stapel organischer Schichten mit einer oder mehreren dotierten Ladungsträgertransportschichten gebildet wird.

7. Verwendung eines oder mehrerer nach einem Verfahren gemäß mindestens eines der Ansprüche 1 bis 6 hergestellter, top-emittierender Bauteile in einer Beleuchtungseinrichtung.

## Claims

1. Method for producing a top-emitting device, in particular organic light-emitting diode, in which:
- a layer arrangement is applied on a substrate,
- the layer arrangement is formed with a bottom electrode arranged on the substrate and a top electrode, through which a light emission is effected, and with a stack of organic layers arranged between the bottom electrode and the top electrode, and
- a surface of the bottom electrode facing the stack of organic layers is formed in light-reflecting fashion at least in a partial region and is provided with a surface roughness that defines a reflection of light generated in the stack of organic layers at the bottom electrode,
**characterized in that**
- the substrate is formed as a polymer layer or as a metal layer and
- an embossed surface structure with structure elements having dimensions in the region of the wavelength of visible light is formed in the region of the surface facing the stack of organic layers by means of mechanical shaping, namely embossing by means of stamping or by means of pressure rolling.

2. Method according to claim 1, wherein the polymer layer is formed from a ductile polymer material.

3. Method according to claim 1, wherein the polymer layer is formed from a thermoplastic polymer material.

4. Method according to claim 1, wherein the polymer layer is formed from a partly crystalline polymer material.

5. Method according to one of the preceeding claims, wherein the embossed surface structure is formed as an irregular surface structure.

6. Method according to one of the preceeding claims, wherein the stack of organic layers is formed with on or a plurality of doped charged carrier transport layers.

7. Use of a top-emitting device in an illumination device, wherein the top-emitting device is produced according to one of the claims 1 to 6.

## Revendications

1. Procédé pour la fabrication d'un composant à émission par le haut, en particulier une diode électroluminescente organique, dans lequel :
- un arrangement de couches est appliqué sur un substrat,
- l'arrangement de couches est formé par une électrode de base disposée sur le substrat et une électrode de couverture à travers laquelle une émission de lumière se produit, ainsi que par une pile de couches organiques disposée entre l'électrode de base et l'électrode de couverture, et
- une surface de l'électrode de base, orientée vers la pile de couches organiques, est formée au moins dans un domaine partiel de manière à réfléchir la lumière et est dotée d'une rugosité de surface qui définit une réflexion de la lumière générée par la pile de couches organiques au niveau de l'électrode de base,
**caractérisé en ce que**
- le substrat est formé comme couche polymère ou couche métallique et
- au niveau de la surface orientée vers la pile de couches organiques, une structure superficielle étampée avec des éléments structurels de dimensions de l'ordre de la longueur d'onde de la lumière visible est formée par façonnage mécanique, notamment l'estampage au moyen de poinçons ou de rouleaux compresseurs.

2. Procédé selon la revendication 1, **caractérisé en ce que** la couche polymère est formée à partir d'un matériau polymère ductile.

3. Procédé selon la revendication 1, **caractérisé en ce que** la couche polymère est formée à partir d'un matériau polymère thermoplastique.

4. Procédé selon la revendication 1, **caractérisé en ce que** la couche polymère est formée à partir d'un matériau polymère partiellement cristallin.

5. Procédé selon l'une quelconque des revendications précédentes, **caractérisé en ce que** la structure superficielle étampé est formée comme structure superficielle irrégulière.

6. Procédé selon l'une quelconque des revendications précédentes, **caractérisé en ce que** la pile de couches organiques est formée avec une ou plusieurs couches de transport de porteurs de charge dopées.

7. Utilisation d'un ou de plusieurs composants à émission par le haut fabriqués selon au moins l'une des revendications 1 à 6 dans un équipement d'éclairage.
